# EUROPEAN PATENT SPECIFICATION

(11) **EP 1 727 211 B1**
(45) Date of publication and mention of the grant of the patent: **15.04.2015**
(21) Application number: 06010769.5
(22) Date of filing: 24.05.2006
(51) Int. Cl.: H01L 31/0224, H01L 27/142

(54) **Method of fabricating a thin-film solar cell, and thin-film solar cell**
Dünnschichtsolarzelle und ihr Herstellungsverfahren
Cellule solaire en couches minces et son procédé de fabrication

(30) Priority: 27.05.2005 JP 2005155980
(43) Date of publication of application: 29.11.2006
(73) Proprietor: Sharp Kabushiki Kaisha, Osaka-shi, Osaka 545-8522 (JP)
(72) Inventor: Takeda, Toru, Kashiba-shi Nara 639-0227 (JP); Tachibana, Shinsuke, Kashiba-shi Nara 639-0266 (JP)
(74) Representative: Müller Hoffmann & Partner

(56) References cited:
- WO-A-03/061013
- US-A- 4 663 494
- PATENT ABSTRACTS OF JAPAN vol. 010, no. 050 (E-384), 27 February 1986 (1986-02-27) -& JP 60 206077 A (TAIYOU YUUDEN KK), 17 October 1985 (1985-10-17)
- PATENT ABSTRACTS OF JAPAN vol. 009, no. 053 (E-301), 7 March 1985 (1985-03-07) -& JP 59 193075 A (HANDOUTAI ENERUGII KENKYUSHO:KK), 1 November 1984 (1984-11-01)

## Description

This nonprovisional application is based on Japanese Patent Application No. 2005-155980 filed with the Japan Patent Office on May 27.

### BACKGROUND OF THE INVENTION

### Field of the Invention

The present invention relates to methods of fabricating thin-film solar cell, and such thin-film solar cell, and particularly to methods of fabricating thin-film solar cell capable of reducing a leak current at a perimeter thereof, and such thin-film solar cell.

### Description of the Background Art

Various types of solar cell converting the energy of sunlight directly to electrical energy have been practically used. Among others, a thin-film solar cell that employs thin amorphous silicon film is actively being developed as it is readily processed at low temperature and increased in area to have a large area and can hence be fabricated inexpensively.

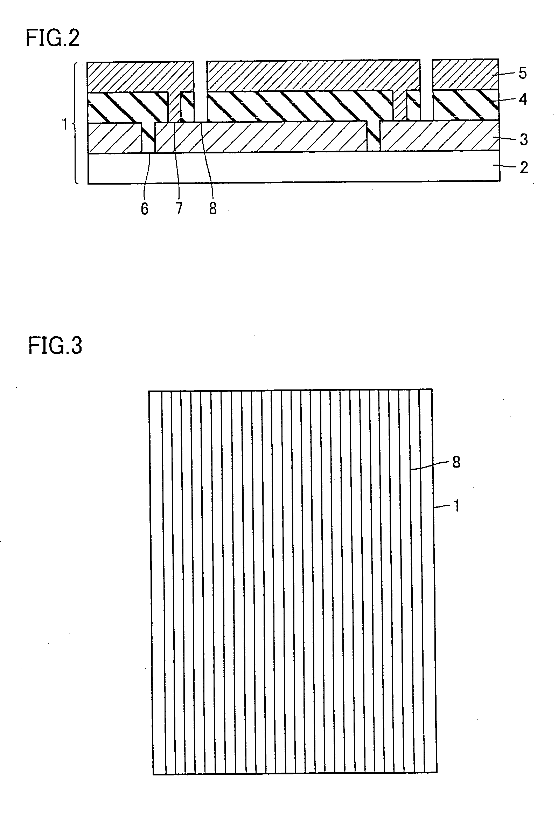

Fig. 2 is a schematic cross section of a portion of a conventional thin-film solar cell. In Fig. 2 a thin-film solar cell 1 includes a transparent electrode layer 3, a photoelectric conversion semiconductor 4 formed of thin amorphous silicon film, and a back surface electrode layer 5 on a transparent insulator substrate 2 in this order. Note that transparent electrode layer 3 is divided by a first isolation groove 6 having photoelectric conversion semiconductor layer 4 introduced therein into a plurality of such layers isolated, and photoelectric conversion semiconductor layer 4 and back surface electrode layer 5 is each divided by a second isolation groove 8 into a plurality of such layers isolated. Adjacent cells with a contact line 7, which is a portion from which photoelectric conversion semiconductor layer 4 is removed by patterning employing a laser light or the like, posed therebetween, are electrically, series-connected.

Thin-film solar cell 1 is fabricated for example as follows: Initially on transparent insulator substrate 2 transparent electrode layer 3 is deposited and thereafter laser-scribed to remove a portion of transparent electrode layer 3 to form the first isolation groove 6 to divide transparent electrode layer 3 into a plurality of such layers isolated. Subsequently, on transparent electrode layer 3 divided into the plurality of such layers isolated, plasma CVD is employed to deposit in order a p layer, an i layer and an n layer of thin amorphous silicon film to form photoelectric conversion semiconductor layer 4. Then photoelectric conversion semiconductor layer 4 is laser-scribed to remove a portion of photoelectric conversion semiconductor layer 4 to form contact line 7 to divide photoelectric conversion semiconductor layer 4 into a plurality of such layers isolated. Subsequently, back surface electrode layer 5 is deposited to fill contact line 7 and also cover photoelectric conversion semiconductor layer 4. Finally, photoelectric conversion semiconductor layer 4 and back surface electrode layer 5 are laser-scribed to form the second isolation groove 8 dividing photoelectric conversion semiconductor layer 4 into a plurality of such layers isolated and back surface electrode layer 5 into a plurality of such layers isolated. Thin-film solar cell 1 shown in Fig. 2 is thus fabricated.

Fig. 3 is a schematic plan view of thin-film solar cell 1 shown in Fig. 2, as seen from a side of back surface electrode layer 5. Thin-film solar cell 1 typically has a perimeter provided with a metallic frame for reinforcement. Accordingly, to ensure insulation between the metallic frame and thin-film solar cell 1, it is necessary to remove the transparent electrode layer, the photoelectric conversion semiconductor layer and the back surface electrode layer at the perimeter of thin-film solar cell 1. The transparent electrode layer, the photoelectric conversion semiconductor layer and the back surface electrode layer at the perimeter are removed, hereinafter also referred to as "trimming", by various techniques. For example, the layers are mechanically ground, chemically etched, laser-scribed, or the like. In particular, laser-scribing is typically adopted. Typically, a fundamental harmonic of YAG laser light (IR) is directed from a side of the transparent insulator substrate to irradiate the perimeter of the thin-film solar cell to allow the transparent electrode layer to absorb the energy of the irradiation and by the heat thereof the transparent electrode layer, the photoelectric conversion semiconductor layer and the back surface electrode layer are simultaneously volatilized.

The document WO-A-03 061 013 discloses a method of fabricating a thin-film solar cell including a transparent electrode layer, a photoelectric conversion semiconductor layer and a back surface electrode layer deposited on a transparent insulator substrate in this order, comprising the steps of: irradiating a first laser light from the side of said transparent insulator substrate to remove said photoelectric conversion semiconductor layer and said back surface electrode layer at a region irradiated with said first laser light with transparent electrode layer remaining unremoved; irradiating a second laser light from a side of a transparent insulator substrate to remove a transparent electrode layer.

Furthermore each of documents US-A-4 663 494 and JP-A-60 206 077 discloses a thin-film solar cell including a transparent electrode layer, a photoelectric conversion semiconductor layer and a back surface electrode layer deposited on a transparent insulator substrate in this order, wherein said thin-film solar cell has a perimeter with said transparent electrode layer protruding beyond said photoelectric conversion semiconductor layer and said back surface electrode layer.

### SUMMARY OF THE INVENTION

If the trimming method with a conventional laser scribing method is adopted, however, a portion of the transparent electrode layer volatilized by the irradiation of the fundamental harmonic of the YAG laser light adheres on a vertical cross section of the photoelectric conversion semiconductor layer. This forms a leak path between the transparent electrode layer and the back surface electrode layer, and the leak path passes a leak current resulting in the thin-film solar cell having reduced conversion efficiency.

Accordingly, the purpose of the present invention is to provide a method of fabricating a thin-film solar cell capable of reducing a leak current caused at a perimeter of the thin-film solar cell, and such thin-film solar cell.

The present invention provides a method of fabricating a thin-film solar cell as set out in claim 1.

In the present method of fabricating the thin-film solar cell the first laser light can be a second harmonic of YAG laser light.

Furthermore in the present method of fabricating the thin-film solar cell the second laser light can be a fundamental harmonic of YAG laser light.

Thus the present invention can provide a method of fabricating a thin-film solar cell capable of reducing a leak current caused at a perimeter of the thin-film solar cell.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic cross section illustrating a preferred example of a method of fabricating a thin-film solar cell in accordance with the present invention.
Fig. 2 is a schematic cross section of a portion of a conventional thin-film solar cell.
Fig. 3 is a schematic plan view of the thin-film solar cell shown in Fig. 2, as seen from a side of a back surface electrode layer.
Fig. 4 is a schematic cross section illustrating a method of fabricating a thin-film solar cell of a first comparative example.

### DESCRIPTION OF THE PREFERRED EMBODIMENTS

Hereinafter an embodiment of the present invention will be described. Note that in the figures, identical reference characters denote identical or like components.

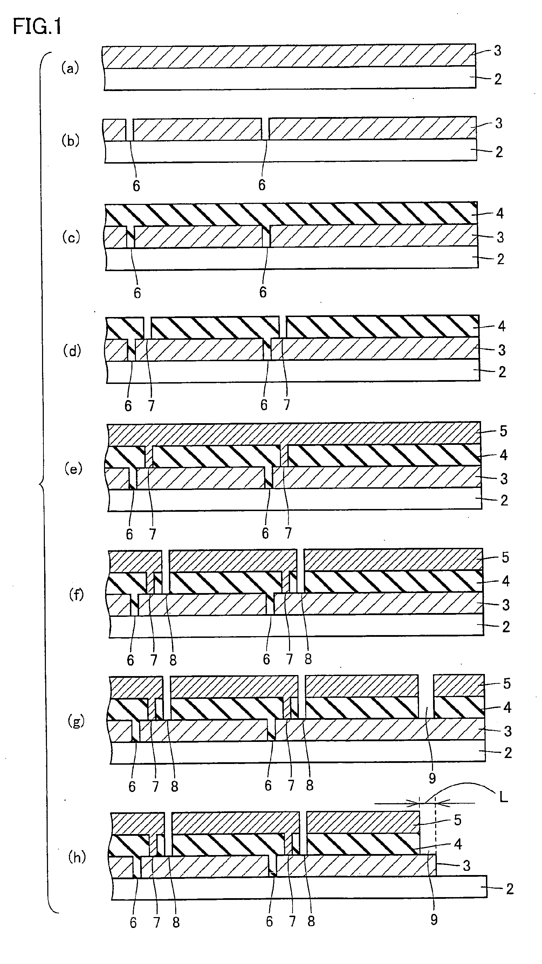

Figs. 1(a)-1(h) are schematic cross sections illustrating one preferred example of a method of fabricating a thin-film solar cell in accordance with the present invention. Initially, as shown in Fig. 1 (a), transparent insulator substrate 2 has transparent electrode layer 3 deposited thereon. Herein, transparent insulator substrate 2 can for example be a glass substrate or the like. Furthermore, transparent electrode layer 3 can for example be a layer formed for example of tin oxide (SnO₂), indium tin oxide (ITO) or zinc oxide (ZnO). The technique employed to deposit transparent electrode layer 3 is not limited to a particular technique. For example transparent electrode layer 3 can be deposited, as conventionally known, such as sputtered, vapor-deposited, ion-plated, or the like.

Then, as shown in Fig. 1(b), transparent electrode layer 3 is for example laser-scribed and thus partially removed to form a first isolation groove 6 to divide transparent electrode layer 3 into a plurality of such layers isolated.

Then, as shown in Fig. 1(c), the plurality of thus divided, transparent electrode layers 3 has photoelectric conversion semiconductor layer 4 deposited on a surface thereof. In doing so, the first isolation groove 6 is filled with photoelectric conversion semiconductor layer 4. Herein, photoelectric conversion semiconductor layer 4 can for example have: a structure having a p layer formed of thin amorphous silicon film, an i layer formed of thin amorphous silicon film and deposited on the p layer, and an n layer formed of thin amorphous silicon film and deposited on the i layer; a structure having a p layer formed of thin microcrystalline silicon film, an i layer formed of thin microcrystalline silicon film and deposited on the p layer, and an n layer formed of thin microcrystalline silicon film and deposited on the i layer; a structure having a p layer formed of thin amorphous silicon film, an i layer formed of thin amorphous silicon film and deposited on the p layer, and an n layer formed of thin amorphous silicon film and deposited on the i layer, and a structure having a p layer formed of thin microcrystalline silicon film, an i layer formed of thin microcrystalline silicon film and deposited on the p layer, and an n layer formed of thin microcrystalline silicon film and deposited on the i layer, that are combined together to provide a tandem structure; a structure having a p layer formed of thin amorphous silicon film, an i layer formed of thin amorphous silicon film and deposited on the p layer, and an n layer formed of thin amorphous silicon film and deposited on the i layer, and a structure having a p layer formed of thin microcrystalline silicon film, an i layer formed of thin microcrystalline silicon film and deposited on the p layer, and an n layer formed of thin microcrystalline silicon film and deposited on the i layer, with an intermediate layer formed for example of ZnO posed between the structures. Furthermore, such as a structure having p and i layers each of thin amorphous silicon film and an n layer of thin microcrystalline silicon film combined together, at least one of p, i and n layers may be formed of thin amorphous silicon film and the other layers may be formed of thin microcrystalline silicon film to implement the p, i and n layers by a mixture a layer(s) formed of thin amorphous silicon film and a layer(s) formed of thin microcrystalline silicon film.

Herein, the thin amorphous silicon film can be thin-film formed of a hydrogenated amorphous silicon-based semiconductor (a-Si: H) having a dangling bond of silicon terminated by hydrogen, and the thin microcrystalline silicon film can be implemented by thin-film formed of a hydrogenated, microcrystalline silicon-based semiconductor (µc-Si: H) having a dangling bond of silicon terminated by hydrogen.

Furthermore, photoelectric conversion semiconductor layer 4 can have a thickness for example of at least 100 nm and at most 600 nm.

Furthermore, the technique employed to deposit photoelectric conversion semiconductor layer 4 employed in the present invention is not limited to a particular technique. For example, photoelectric conversion semiconductor layer 4 can be deposited by plasma-CVD

Then, as shown in Fig. 1(d), photoelectric conversion semiconductor layer 4 is for example laser-scribed and thus partially removed to form contact line 7 to divide photoelectric conversion semiconductor layer 4 into a plurality of such layers isolated.

Then, as shown in Fig. 1(e), photoelectric conversion semiconductor layer 4 has back surface electrode layer 5 deposited on a surface thereof. In doing so, contact line 7 is filled with back surface electrode layer 5. Herein, back surface electrode layer 5 can for example be implemented by a thin metallic film formed of silver or aluminum and a transparent conductive film such as ZnO that are stacked in layers. The thin metallic film can have a thickness for example of at least 300 nm and at most 1 µm and the transparent conductive film can have a thin thickness for example of at least 50 nm and at most 200 nm.

While back surface electrode layer 5 may be formed of a single or plurality of layers of thin metallic film alone, introducing the transparent conductive film between the single or plurality of layers of thin metallic film and photoelectric conversion semiconductor layer 4 is preferable as such can prevent metal atoms from diffusing from the thin metallic film into photoelectric conversion semiconductor layer 4 and also provide a tendency to increase the sunlight reflectance of the thin metallic film. Furthermore, the technique employed to deposit back surface electrode layer 5 is not limited to a particular technique. For example, back surface electrode layer 5 can be sputtered.

Then, as shown in Fig. 1(f), photoelectric conversion semiconductor layer 4 and back surface electrode layer 5 are for example laser-scribed to form a second isolation groove 8 dividing photoelectric conversion semiconductor layer 4 into a plurality of such layers isolated and back surface electrode layer 5 into a plurality of such layers isolated.

Then, a first laser light is irradiated from a side of transparent insulator substrate 2 so that a portion of photoelectric conversion semiconductor layer 4 and back surface electrode layer 5 that is irradiated by the first laser light is volatilized and thus removed to form a removed portion 9. Herein, the first laser light can be implemented for example by a second harmonic of YAG laser light (wavelength: 532 nm). The second harmonic of YAG laser light has a tendency to be transmitted through transparent insulator substrate 2 and transparent electrode layer 3 and absorbed into photoelectric conversion semiconductor layer 4. As such, if the second harmonic of YAG laser light is employed as the first laser light, photoelectric conversion semiconductor layer 4 can selectively be heated, and by the heat, photoelectric conversion semiconductor layer 4 and back surface electrode layer 5 adjacent thereto can be volatilized. Note that the second harmonic of YAG laser light preferably has an intensity that does not damage transparent electrode layer 3.

Note that in the present invention the YAG laser refers to an Nd: YAG laser, and the Nd: YAG laser is formed of yttrium aluminum garnet (Y₃Al₅O₁₂) crystal including neodymium ion (Nd³⁺). The YAG laser oscillates a fundamental harmonic of YAG laser light (wavelength: 1064 nm), and that wavelength is halved to obtain the second harmonic of YAG laser light (wavelength: 532 nm).

Finally, from a side of transparent insulator substrate 2, a second laser light is irradiated at a region outer than that irradiated with the first laser light, and, as shown in Fig. 1 (h), a region of transparent electrode layer 3, photoelectric conversion semiconductor layer 4 and back surface electrode layer 5 that is outer than that irradiated with the first laser light is volatilized and thus removed. Herein, the second laser light is preferably implemented by a fundamental harmonic of YAG laser light (wavelength: 1064 nm). The fundamental harmonic of YAG laser light has a tendency to be transmitted through transparent insulator substrate 2 and absorbed into transparent electrode layer 3. As such, if the fundamental harmonic of YAG laser light is employed as the second laser light, transparent electrode layer 3 can selectively be heated, and by that heat, transparent electrode 3, photoelectric conversion semiconductor layer 4 and back surface electrode layer 5 can be volatilized.

Thus, in accordance with the present invention, at a region irradiated with the first laser light, transparent electrode layer 3 can remain unremoved and photoelectric conversion semiconductor layer 4 and back surface electrode layer 5 alone can be removed. Thus, as shown in Fig. 1(h), removed portion 9 exposes a vertical cross section of photoelectric conversion semiconductor layer 4 and back surface electrode layer 5, and when the second laser light is irradiated and thus volatilize transparent electrode layer 3 at a region outer than that irradiated with the first laser light, between the exposed vertical cross section of photoelectric conversion semiconductor layer 4 and back surface electrode layer 5 that is volatilized, there will be a distance at least by the region irradiated with the first laser light (i.e., removed portions 9). Thus, in accordance with the present invention, as compared with volatilizing transparent electrode layer 3, photoelectric conversion semiconductor layer 4 and back surface electrode layer 5 located at a perimeter, all at once, as conventional, the volatilized transparent electrode 3 less readily adheres to the vertical cross section of photoelectric conversion semiconductor layer 4 by the region irradiated with the first laser light (i.e., removed portion 9). A leak current at a perimeter of a thin-film solar cell can thus be reduced. Note that in the present invention the steps shown in Figs. 1(g) and (h) are performed only for a portion of the perimeter of the thin-film solar cell, preferably, such steps are performed for the entirety of the perimeter of the thin-film solar cell.

The thus fabricated, present thin-film solar cell includes transparent electrode layer 3, photoelectric conversion semiconductor layer 4 and back surface electrode layer 5 deposited on transparent insulator substrate 2 in this order, and the thin-film solar cell at a perimeter thereof has transparent electrode 3 protruding outer than photoelectric conversion semiconductor layer 4 and back surface electrode layer 5.

Herein, with reference to Fig. 1(h), transparent electrode layer 3 preferably has a protrusion having a length L (i.e., a smallest horizontal distance between that end of the protrusion of transparent electrode layer 3 closer to the perimeter and that vertical cross section of electric conversion layer of semiconductor 4 closer to the perimeter) of at least 100 µm and at most 1000 µm. If transparent electrode layer 3 has such protrusion with length L less than 100 µm, then processing with the second laser light entails mechanical processing precision, resulting in a tendency that the cost for device increases. Furthermore, in that case, transparent electrode layer 3 volatilized by the second laser light tends to adhere to the exposed vertical cross section of photoelectric conversion semiconductor layer 4. If transparent electrode layer 3 has such protrusion with length L greater than 1000 µm, there is a tendency that the solar cell has a reduced effective power generation region and hence an increased loss.

### Examples

### First Example

Initially, as shown in Fig.1(a), there was prepared transparent insulator substrate 2 implemented by a glass substrate having a surface in the form of a rectangle having a width of 560 mm by a length of 925 mm and having transparent conductive layer 3 formed of SnO₂ deposited thereon.

Then, a fundamental harmonic of YAG laser light was irradiated from a side of transparent insulator substrate 2 to laser-scribe and thus remove a portion of transparent conductive layer 3 in a strip to form, as shown in Fig. 1(b), 50 first isolation grooves 6 of 0.1 mm in width in the longitudinal direction of transparent insulator substrate 2 such that adjacent first isolation grooves 6 had equal intervals therebetween. Transparent insulator substrate 2 was then cleaned with pure water ultrasonically.

Then, plasma CVD was employed to deposit a p layer formed of a boron-doped, hydrogenated amorphous silicon-based semiconductor (a-Si: H), then an i layer formed of an undoped, hydrogenated amorphous silicon-based semiconductor (a-Si: H), and then an n layer formed of a phosphorus-doped, hydrogenated, microcrystalline silicon-based semiconductor (µc-Si: H) to provide photoelectric conversion semiconductor layer 4 as shown in Fig. 1(c).

Subsequently a second harmonic of YAG laser light was irradiated from a side of transparent insulator substrate 2 to irradiate transparent electrode layer 3 at an intensity that does not damage transparent electrode layer 3 to laser-scribe and thus remove a portion of photoelectric conversion semiconductor layer 4 in a strip to form, as shown in Fig. 1 (d), contact line 7 in the longitudinal direction of transparent insulator substrate 2 such that adjacent contact lines 7 had equal intervals therebetween.

Then, ZnO and silver were sputtered successively to deposit transparent conductive film and thin metallic film, respectively, to provide back surface electrode layer 5 as shown in Fig. 1(e).

Then, a second harmonic of YAG laser light was irradiated from a side of transparent insulator substrate 2 to laser-scribe and thus remove a portion of photoelectric conversion semiconductor layer 4 and back surface electrode layer 5 in a strip to form, as shown in Fig. 1(f), second isolation grooves 8 in the longitudinal direction of transparent insulator substrate 2 such that adjacent second isolation grooves 8 had equal intervals therebetween.

Then the second harmonic of YAG laser light was irradiated from a side of transparent insulator substrate 2 to irradiate a perimeter of photoelectric conversion semiconductor layer 4 and back surface electrode layer 5 to laser-scribe and thus remove a portion of layers 4 and 5 in a strip to provide removed portion 9 of 1000 µm in width as shown in Fig. 1(g).

Finally, a region outer than removed portion 9 was irradiated with a fundamental harmonic of YAG laser light from a side of transparent insulator substrate 2 to laser-scribe and thus remove transparent electrode layer 3, photoelectric conversion semiconductor layer 4 and back surface electrode layer 5 at the irradiated portion in a strip having a width of 11 mm as measured from an outer side to fabricate the thin-film solar cell of the first example. The thin-film solar cell of the first example had the transparent electrode layer with a protrusion having length L, as shown in Fig. 1(h), which measured 500 µm.

Then, the thin-film solar cell of the first example was measured for leak current at a perimeter thereof by applying reverse bias voltage for each cell, and measured for conversion efficiency with a solar simulator. The result is shown in Table 1. As shown in Table 1, the thin solar cell of the first example provided a leak current of 12 mA at the perimeter, and a conversion efficiency of 10.9%.

### First Comparative Example

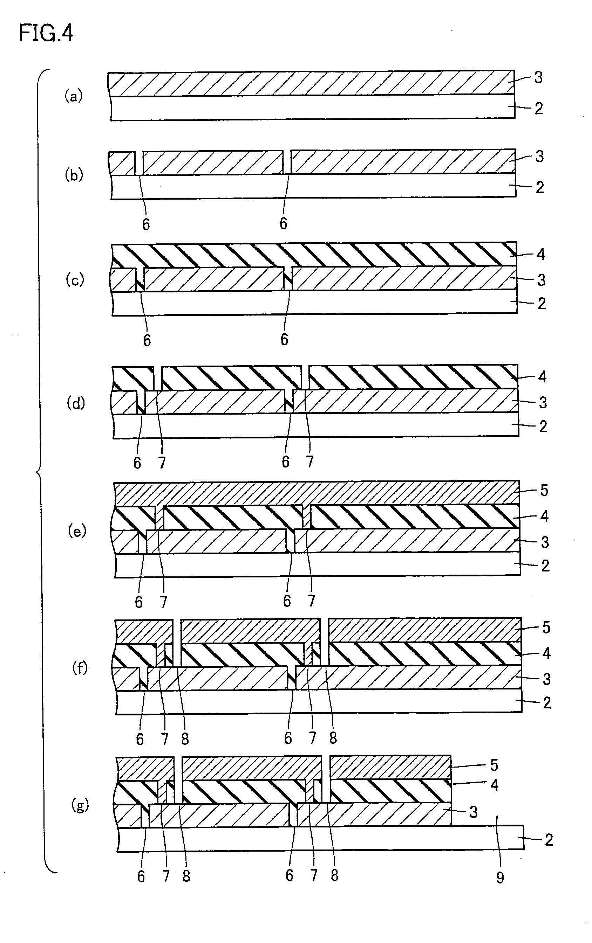

Except that the steps shown in Figs. 1(g) and 1(h) were not performed and a fundamental harmonic of YAG laser light was irradiated from a side of a transparent insulator substrate to remove a transparent electrode layer, a photoelectric conversion semiconductor layer and a back surface electrode layer all at once as shown in Fig. 4(g), the same method as the first example was employed and the same conditions as the first example were applied to fabricate a thin-film solar cell of a first comparative example. More specifically, the method illustrated in the schematic cross sections shown in Figs. 4(a) to 4(g) was employed to fabricate the thin-film solar cell of the first comparative example.

More specifically, initially, as shown in Fig. 4(a), there was prepared transparent insulator substrate 2 implemented by a glass substrate having a surface in the form of a rectangle having a width of 560 mm by a length of 925 mm and having transparent conductive layer 3 formed of SnO₂ deposited thereon.

Then, a fundamental harmonic of YAG laser light was irradiated from a side of transparent insulator substrate 2 to laser-scribe and thus remove a portion of transparent conductive layer 3 in a strip to form, as shown in Fig. 4(b), 50 first isolation grooves 6 of 0.1 mm in width in the longitudinal direction of transparent insulator substrate 2 such that adjacent first isolation grooves 6 had equal intervals therebetween. Transparent insulator substrate 2 was then cleaned with pure water ultrasonically.

Then, plasma CVD was employed to deposit a p layer formed of a boron-doped, hydrogenated amorphous silicon-based semiconductor (a-Si: H), then an i layer formed of an undoped, hydrogenated amorphous silicon-based semiconductor (a-Si: H), and then an n layer formed of a phosphorus-doped, hydrogenated, microcrystalline silicon-based semiconductor (µc-Si: H) to provide photoelectric conversion semiconductor layer 4 as shown in Fig. 4(c).

Subsequently a second harmonic of YAG laser light was irradiated from a side of transparent insulator substrate 2 at an intensity that does not damage transparent electrode layer 3 to laser-scribe and thus remove a portion of photoelectric conversion semiconductor layer 4 in a strip to form, as shown in Fig. 4(d), contact line 7 in the longitudinal direction of transparent insulator substrate 2 such that adjacent contact lines 7 had equal intervals therebetween.

Then, ZnO and silver were sputtered successively to deposit transparent conductive film and thin metallic film, respectively, to provide back surface electrode layer 5 as shown in Fig. 4(e).

Then, a second harmonic of YAG laser light was irradiated from a side of transparent insulator substrate 2 to laser-scribe and thus remove a portion of photoelectric conversion semiconductor layer 4 and back surface electrode layer 5 in a strip to form, as shown in Fig. 4(f), the second isolation groove 8 in the longitudinal direction of transparent insulator substrate 2 such that adjacent second isolation grooves 8 had equal intervals therebetween.

Finally the second harmonic of YAG laser light was irradiated from a side of transparent insulator substrate 2 to laser-scribe and thus remove the perimeter of transparent electrode layer 3, photoelectric conversion semiconductor layer 4 and back surface electrode layer 5, all at once, in a strip to provide removed portion 9 of 1000 µm in width as shown in Fig. 4(g). Thus the thin-film solar cell of the first comparative example completed.

The thin-film solar cell of the first comparative example was then measured for leak current at a perimeter thereof, and measured for conversion efficiency in the same method as applied to the thin-film solar cell of the first example and under the same conditions as applied to the thin-film solar cell of the first example. The result is indicated in Table 1. As shown in Table 1,

**Table 1**

| | First Example | First Comparative Example |
|---|---|---|
| Leak Current | 12mA | 98mA |
| Conversion Efficiency | 10.9% | 10.2% |

As is also apparent from Table 1, the thin-film solar cell of the first example at its perimeter has provided a smaller leak current than that of the first comparative example and as a result has increased in conversion efficiency.

Thus the present invention can provide a method of fabricating a thin-film solar cell capable of reducing a leak current at a perimeter of the thin-film solar cell, and such thin-film solar cell.

Although the present invention has been described and illustrated in detail, it is clearly understood that the same is by way of illustration and example only and is not to be taken by way of limitation, the scope of the present invention being limited only by the terms of the appended claims.

## Claims

1. A method of fabricating a thin-film solar cell (1) including a transparent electrode layer (3), a photoelectric conversion semiconductor layer (4) and a back surface electrode layer (5) deposited on a transparent insulator substrate (2) in this order, comprising the steps of:
irradiating a first laser light from a side of a transparent insulator substrate (2) to remove a photoelectric conversion semiconductor layer (4) and a back surface electrode layer (5) at a region irradiated with said first laser light with said transparent electrode layer (3) remaining unremoved; and
irradiating a second laser light from the side of said transparent insulator substrate (2) to remove said transparent electrode layer (3), said photoelectric conversion semiconductor layer (4) and said back surface electrode layer (5) at a region beyond said region irradiated with said first laser light such that at a perimeter of said thin film solar cell (1) said transparent electrode layer (3) protrudes beyond said photoelectric conversion semiconductor layer (4) and said back surface electrode layer (5)

2. The method of fabricating said thin-film solar cell (1) according to claim 1, wherein said first laser light is a second harmonic of YAG laser light.

3. The method of fabricating said thin-film solar cell (1) according to claim 1, wherein said second laser light is a fundamental harmonic of YAG laser light.

## Patentansprüche

1. Verfahren zum Herstellen einer Dünnschichtsolarzelle (1) mit einer transparenten Elektrodenschicht (3), einer photoelektrischen Wandler-Halbleiterschicht (4) und einer rückseitigen Elektrodenschicht (5), die in dieser Reihenfolge auf einem transparenten isolierenden Substrat (2) aufgebracht sind, umfassend die Schritte:
Bestrahlen mit einem ersten Laserlicht von einer Seite eines transparenten isolierenden Substrats (2) zum Entfernen einer photoelektrischen Wandler-Halbleiterschicht (4) und einer rückseitigen Elektrodenschicht (5) in einem Bereich, der mit dem ersten Laserlicht bestrahlt wird, wobei die transparente Elektrodenschicht (3) nicht entfernt wird; und
Bestrahlen mit einem zweiten Laserlicht von der Seite des transparenten isolierenden Substrats (2) zum Entfernen der transparenten Elektrodenschicht (3), der photoelektrischen Wandler-Halbleiterschicht (4) und der rückseitigen Elektrodenschicht (5) in einem Bereich außerhalb des mit dem ersten Laserlicht bestrahlten Bereichs und zwar derart, dass die transparente Elektrodenschicht (3) in einem Umfang der Dünnschichtsolarzelle (1) über die photoelektrische Wandler-Halbeiterschicht (4) und die rückseitige Elektrodenschicht (5) hervorragt.

2. Verfahren zum Herstellen einer Dünnschichtsolarzelle (1) nach Anspruch 1, wobei das erste Laserlicht ein frequenzverdoppeltes YAG Laserlicht ist.

3. Verfahren zum Herstellen einer Dünnschichtsolarzelle (1) nach Anspruch 1, wobei das zweite Laserlicht ein fundamentales YAG Laserlicht ist.

## Revendications

1. Procédé pour fabriquer une cellule solaire en couches minces (1) comprenant une couche d'électrode transparente (3), une couche semi-conductrice de conversion photoélectrique (4) et une surface d'électrode de surface arrière (5) qui sont déposées dans cet ordre sur un substrat isolant transparent (2), comprenant les étapes :
de projection d'une première lumière laser à partir d'un côté d'un substrat isolant transparent (2), pour enlever une couche semi-conductrice de conversion photoélectrique (4) et une couche d'électrode de surface arrière (5) au niveau d'une zone exposée à ladite première lumière laser, la couche d'électrode transparente (3) restant en place ; et
de projection d'une deuxième lumière laser à partir du côté du substrat isolant transparent (2) pour enlever la couche d'électrode transparente (3), la couche semi-conductrice de conversion photoélectrique (4) et la couche d'électrode de surface arrière (5) au niveau d'une zone située au-delà de la zone exposée à la première lumière laser, de sorte que sur un périmètre de la cellule solaire en couches minces (1), la couche d'électrode transparente (3) dépasse de la couche semi-conductrice de conversion photoélectrique (4) et de la couche d'électrode de surface arrière (5).

2. Procédé pour fabriquer ladite cellule solaire en couches minces (1) selon la revendication 1, étant précisé que la première lumière laser est un deuxième harmonique de la lumière laser YAG.

3. Procédé pour fabriquer ladite cellule solaire en couches minces (1) selon la revendication 1, étant précisé que la deuxième lumière laser est un harmonique fondamental de la lumière laser YAG.
